# EUROPEAN PATENT SPECIFICATION

(11) **EP 0 980 595 B1**
(45) Date of publication and mention of the grant of the patent: **27.10.2004**
(21) Application number: 98922166.8
(22) Date of filing: 08.05.1998
(51) Int. Cl.: H01S 3/14

(54) **ORGANIC LASERS**
ORGANISCHE LASER
LASERS ORGANIQUES

(30) Priority: 09.05.1997 US 46061 P; 19.05.1997 US 859468; 18.07.1997 US 53176 P; 22.01.1998 US 10594; 07.05.1998 US 73843
(43) Date of publication of application: 23.02.2000
(73) Proprietor: The Trustees of Princeton University, Princeton, New Jersey 08544 (US)
(72) Inventor: FORREST, Stephen, R., Princeton, NJ 08540 (US); BULOVIC, Vladimir, Metuchen, NJ 08840 (US); BURROWS, Paul, Princeton Junction, NJ 08550 (US); KOZLOV, Vladimir, Plainsboro, NJ 08536 (US)
(74) Representative: Meyer-Dulheuer, Karl-Hermann, Dr.
(86) International application number: PCT/US1998/009480
(87) International publication number: WO 1998/050989

(56) References cited:
- US-A- 4 395 769
- US-A- 5 307 363
- US-A- 5 343 050
- US-A- 5 405 710
- US-A- 5 739 545
- US-A- 6 111 902
- KOZLOV V G ET AL: "Organic semiconductor laser" CONFERENCE PROCEEDINGS. LEOS '97, 10TH ANNUAL MEETING. IEEE LASERS AND ELECTRO-OPTICS SOCIETY 1997 ANNUAL MEETING (CAT. NO.97CH36057), CONFERENCE PROCEEDINGS. LEOS '97. 10TH ANNUAL MEETING IEEE LASERS AND ELECTRO-OPTICS SOCIETY 1997 ANNUAL MEETING, S, pages 175-176 vol.2, XP002209992 1996, New York, NY, USA, IEEE, USA ISBN: 0-7803-3895-2
- BERGGREN M ET AL: "Stimulated emission and lasing in dye-doped organic thin films with Forster transfer" APPLIED PHYSICS LETTERS, 20 OCT. 1997, AIP, USA, vol. 71, no. 16, pages 2230-2232, XP002209993 ISSN: 0003-6951
- SALEH B.E.A. ET AL: 'Fundamentals of Photonics', 1991, JOHN WILEY & SONS, INC., NEW-YORK

## Description

### Field Of The Invention

The present invention relates to the field of light emitting devices, in particular, to laser light emitting devices containing organic materials.

### Background Information

Several recent publications have reported phenomena such as superluminescence and amplified spontaneous emission in polymeric organic light emitters such as conjugated polymers. (N. Tessler et al., Nature 382, 695 (1996); F. Hide et al., Science 273, 1833 (1996)). The materials used in those emitters are spin-coated from a solution of the polymer or its chemical precursors. Optically pumped, stimulated emission from organic laser dyes, introduced into inert, spin-coated polymers or gels has been described in the literature. (R. E. Hermes, et al., Appl. Phys. Lett. 63, 877 (1993); M.N. Weiss et al., Appl. Phys. Lett. 69, 3653 (1996); H. Kogelnik et al., Appl. Phys. Lett. 18, 152 (1971); M. Canva et al., Appl. Opt., 34, 428 (1995)).

When compared with other electrolumninescent materials, however, spun-on polymeric materials do not exhibit particularly good thickness uniformity, ability to achieve extremely high materials purity, operating lifetimes, and ease of integration with other conventional semiconductor fabrication processes. In the field of organic light emitting devices (OLEDs) for flat panel display applications, for example, small molecule OLEDs currently offer better operating lifetimes by an order of magnitude over their spin-coated, polymeric analogs.

There is much recent interest in lasing action and stimulated emission in thin films of small molecular weight organic semiconductors and polymers as organic semiconductor lasers ("OSLs"). The low cost of organic materials and ability to grow them as quasi- and non-epitaxial thin films facilitates integration of OSLs with other optoelectronic devices, making them attractive for a number of applications. The particular optical and electronic properties of organic semiconductors result in OSL performance that is significantly more temperature stable than conventional inorganic laser diodes, a potential advantage in optical communications and sensor applications. For example, the lasing action in optically-pumped slab waveguide structures of vacuum-deposited thin films of small molecular weight organic semiconductors has been recently demonstrated. (See V.G. Kozlov et al., Conf on Lasers and Electro-optics CLEO '97, CPD-18, Opt. Soc. Am., Baltimore, MD, May 1997). The output power, differential quantum efficiency, and emission wavelength of these organic semiconductor lasers (OSLs) are significantly more stable to changes in temperature than conventional inorganic laser diodes. This benefit of organic laser structures combined with the inherent advantages of organic semiconductors such as low cost, quasi- and non-epitaxial growth (S.R. Forrest et al., Phys. Rev. B 49, 11309 (1994)). and ease of integration with other optoelectronic devices, provides strong motivation for further research. Presently, there is an interest in the development of OSL structures that result in desired OSL properties such as narrow bandwidth emission, the minimal use of active organic materials, and the facilitation of wavelength tuning and electrical pumping.

From U.S. patent 5.405.710 an apparatus with at least two optical microcavity light emitters is known. Each of these light emitters comprises spaced apart reflectors that define a microcavity, and further comprises organic material that is capable of electro-luminescence (e.g., tris (8-hydroxyquinolinol) aluminium, commonly referred to as "alq"), and means for applying an electric field across the organic material. One of the at least two microcavities has effective optical length L₁ and the other microcavity has effective optical length L₂≠L₁, with the optical lengths selected such that one of the microcavities emits radiation of a first color (e.g., red), and the other microcavity emits radiation of a second color (e.g., green). In many cases there will be present also a third microcavity that emits radiation of a third color (e.g., blue). In preferred embodiments there is present within the microcavities a filler layer, of thickness selected to provide to a given microcavity the desired optical length. A preferred embodiment of the invention is a full color flat panel display that comprises many pixels, each pixel comprising at least three different microcavity emitters. Other contemplated embodiments are a LED printer, an optical interconnect and an optical fiber communication system.

From U.S. patent 4.395.769 a tunable semiconductor laser is known which provides tunable laser radiation by pumping a wedge-shaped ultra-short laser cavity with picosecond excitation pulses. Continuous tuning of the laser is achieved by translating either the wedge-shaped laser cavity or the excitation pulses so that different volumes of the laser material are exposed to the < excitation pulses. In one embodiment utilizing picosecond laser excitation pulses the wedge-shaped laser cavity is a slightly wedged film of GaAs coated on both sides with dielectric mirrors.

From U.S. patent 7.539.545 organic light emitting diodes are known having a transparent cathode structure. The structure consists of a low work function metal in direct contact with the electron transport layer of the OLED covered by a layer of a wide bandgap semiconductor. Calcium is the preferred metal because of its relatively high optical transmissivity for a metal and because of its proven ability to form a good electron injecting contact to organic materials. ZnSe, ZnS or an alloy of these materials are the preferred semiconductors because of their good conductivity parallel to the direction of light emission, their ability to protect the underlying low work function metal and organic films and their transparency to the emitted light. Arrays of these diodes, appropriately wired, can be used to make a self-emissive display. When fabricated on a transparent substrate, such a display is at least partially transparent making it useful for heads-up display applications in airplanes and automobiles. Such a display can also be fabricated on an opaque substrate, such as silicon, in which previously fabricated devices and circuits can be used to drive the display.

The documment US-6,111,502 discloses an organic laser comprising an organic gain medium layer on a substrate, said gain medium layer presenting two parallel reflecting facets forming a resonator, and an optical pumping source.

### Summary of the Invention

The invention is defined in claim 1. Further embodiements are defined in claims 2-14.

The present invention is directed to laser devices that include organic materials that lase when pumped to thereby produce laser light. The invention includes both optically and electrically pumped embodiments of unique structure and organic laser materials. In contrast to spun-on polymeric materials, the organic materials used in the present invention offer the advantages of excellent thickness uniformity, extremely high materials purity, and ease of integration with conventional fabrication processes. Moreover, the laser devices of the present invention provide a clear threshold in output power, well-defined laser beams, cavity modes, and spectral line narrowing.

The present invention includes a laser comprising a mirror layer and a layer of active organic material over the mirror layer. The active organic material lases when pumped to thereby produce laser light. The mirror layer reflects at least a portion of the light produced by the first active organic material.

In one aspect, the present invention relates to optically-pumped lasers which include a source of optical pump energy for pumping the active organic material.

In another aspect, the present invention relates to electrically-pumped lasers in which the active organic material is electroluminescent and is disposed between a pair of electrodes. The active organic material is pumped when an electric current is passed between the electrodes.

### Brief Description of the Drawings

Fig. 1 shows an arrangement including an embodiment of a laser device according to the present invention.
Fig. 2 shows an arrangement including an embodiment of a laser device according to the present invention.
Fig. 3 is a graphical representation of the relationship between peak output power and pump energy density for an embodiment of the present invention.
Fig. 4 (inset to Fig. 3) shows the polarization of the emission of an embodiment of the present invention, as a function of the angle between a plane orthogonal to the film surface and the plane of a polarizer.
Figs. 5A and 5A show electrically-pumped laser device embodiments of the present invention.
Fig. 6 shows a cross-section of a laser cavity structure in accordance with an embodiment of the present invention.
Fig. 8A - 8H show the chemical formulae for DCM (=4-(dicyanomethylene)-2-methyl-6-(para-(diaminostyryl)-4H-pyran)), Alq₃ (=tris(8-hydroxyquinoline)), CBD (=chlorobiphenyl). DCM2 (=2-methyl-6-2-(2,3,6,7-tetrahydro-1H,5H-benzo-quinolizin-9-yl)ethenA-4H-pyran4-ylidene-propano-dinitril, rhodamine-6G, coumarin-47, perylene, and pyrromethane-546, respectively.
Fig. 9 shows a cross-section of a tunable optically-pumped laser, in accordance with an embodiment of the present invention.
Fig. 10 shows a cross-section of an electrically-pumped laser, in accordance with an embodiment of the present invention.
Fig. 11 shows a cross-section of a stacked, multicolour electrically-pumped laser, in accordance with an embodiment of the present invention.
Fig. 12 shows a cross-section of a tunable electrically-pumped laser, in accordance with an embodiment of the present invention.
Fig. 13 shows a cross-section of a waveguide reducing structure, in accordance with an embodiment of the present invention.
Fig. 14 shows emission spectra for an optically-pumped laser device, in accordance with an embodiment of the present invention.
Fig. 15 shows the spontaneous emission spectrum in the substrate normal direction from an exemplary embodiment of an OVCSEL in accordance with the present invention.
Fig. 16 shows the emission spectrum, at a high excitation level, from an exemplary embodiment of an OVCSEL of the present invention.
Fig. 17 shows a high resolution emission spectrum from an exemplary embodiment of an OVCSEL of the present invention as a function of excitation near the lasing threshold.
Fig. 18 shows the dependence of output energy on the input pump energy near the lasing threshold for an exemplary embodiment of an OVCSEL of the present invention.

### Detailed Description

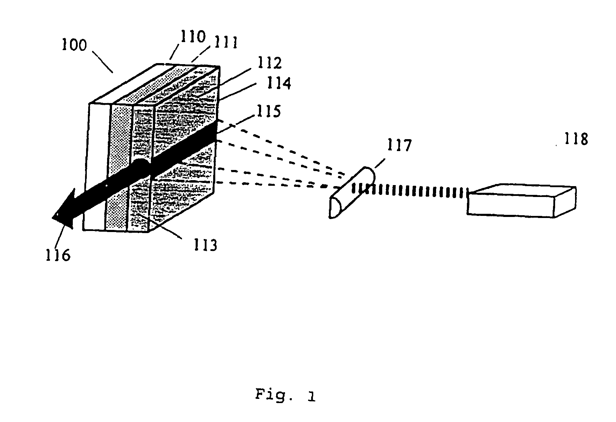

One embodiment of an optically-pumped laser device 100 of the present invention is shown in Fig. 1. The laser device 100 includes a first mirror layer 110 and a layer 112 of active organic material. The first mirror layer 110 is a "mirror" in that it is capable of reflecting at least some portion of the light emitted from the layer 112 of organic material. For example, many of the mirror layers used in the devices of the present invention are used to transmit laser light of preferred characteristics such as wavelength, orientation, bandwidth, brightness, and the like, while reflecting light having non-preferred characteristics. The mirror layers used in the present invention include, for example, substrates of glass, quartz, sapphire or plastic, polished InP layers, distributed Bragg reflectors, metallic mirrors and the like.

The organic materials used in the present invention are "active" in that they lase when pumped by any suitable means, such as by optical or electrical energy, to thereby produce laser light. The active organic materials include host and dopant materials, which are deposited by any suitable technique onto first mirror layer 110. The first mirror layer 110 is optionally pre-coated with a cladding layer 111 comprising a material having an index of refraction less than the organic material of layer 112. When the layer 112 is pumped with optical pump energy from a source such as a nitrogen laser 118, the laser device 100 produces laser beam 116 of a predetermined color.

Layers 111 and 112 are of any suitable thickness. By way of example, layers 111 and 112 in the embodiment shown in Fig. 1 are approximately 2 µm and 120 nm, respectively. The thickness of the cladding layer 111 is preferably chosen to provide optical isolation of the layer 112 from the opague first mirror layer 110. The thickness of the layer 112 is chosen to provide uniform pumping and to optimize the ability of the layer to function as an optical waveguide between the cladding layer 111 and the surrounding environment. For example, when layer 112 comprises CBP, a thickness of 120 nm results in approximately 60% absorption of pump energy and a waveguiding confinement factor of approximately 59% at λ= 485 nm. To further facilitate the waveguiding capability of layer 112, cladding layer 111 has an index of refraction less than layer 112 and thus serves to increase optical confinement in layer 112 in the direction normal to the surface of the device. As an example, the cladding layer 111 comprises SiO₂ (refractive index, "n", of about 1.5) when the layer 112 comprises CBP as host organic material (n∼1.8). The cladding layer 111 may not be required, for example, where the first mirror layer 110 is intended for laser emission therethrough. However, in the embodiment shown in Fig. 1 in which laser emission occurs through the side 113 of the layer 112, the cladding layer 111 is preferred. In addition, layer 112 preferably includes two reflective facets 113 and 114 that are substantially parallel to each other, thereby forming an optical resonator in layer 112.

Layers 111 and 112 are deposited onto the first mirror layer 110 by any suitable technique, such as by plasma enhanced chemical vapor deposition and vacuum thermal evaporation, respectively. The concentration of the dopant in the layer 112 is typically less than 10% by mass, but can be as low as 0.01%. It is generally preferred that the layer 112 is deposited by thermal co-evaporation of host and dopant materials at a respective mass ratio of approximately 100:1.

The laser devices of the present invention are grown on any mirror layer to which the organic layer 112 will adhere and which preferably has a lower index of refraction (n) than the organic layer material. Acceptable mirror layer materials include plastics, glass and silicon coated with SiO₂. A preferred first mirror layer material is polished InP. A typical length for a device in accordance with the present invention is 5 mm, although devices of shorter length, such as 0.5 mm, are possible.

The formation of optically smooth, sharp facets 113 and 114 at opposing edges of the layer 112 is a natural advantage of vacuum-deposited films. The shape of the facets 113 and 114 mimic the shape of the corresponding facets of the underlying first mirror layer 110 (or cladding layer 111, if used). As such, it is preferred that the sides of·the first mirror layer 110 be smooth and parallel to each other. Facet reflectivities of 7% are obtained via vacuum deposition of layer 112, which is sufficient to provide the necessary optical feedback. Optical feedback is also achieved with other structures, such as an optical grating placed underneath the optically pumped region of the organic film to thereby form a distributed feedback structure. As an alternative to forming the facets 113 and 114 by vacuum-deposition of layer 112, layer 112 can be deposited onto the first mirror layer 110 (or cladding layer 111, if used) by any other suitable method, and the combination is then cleaved to form smooth, sharp facets.

Any optically pumped embodiment of the present invention such as the device 100 is pumped using a light source that emits light that can be absorbed by the host material molecular species of layer 112. For example, the device 100 is optically pumped with a nitrogen laser 118 which generates 500 ps pulses with a wavelength of 337 nm at a 50 Hz repetition rate. As shown in Fig. 1, the pump beam is focused, such as by a cylindrical lens 117, into a stripe 115 on the film surface oriented orthogonal to the facets 113 and 114. The width of the stripe 115 is any suitable dimension, such as 100µm, for example. The pump beam is waveguided in layer 112, thereby producing laser beam 116, which is emitted from the facet 113 and/or 114 of the device 100. Moreover, through a gain-guiding effect, the refractive index of the illuminated portion 115 of the organic layer 112 will be higher than that of the non-illuminated portion, thereby providing confinement of the optical mode in the vertical direction.

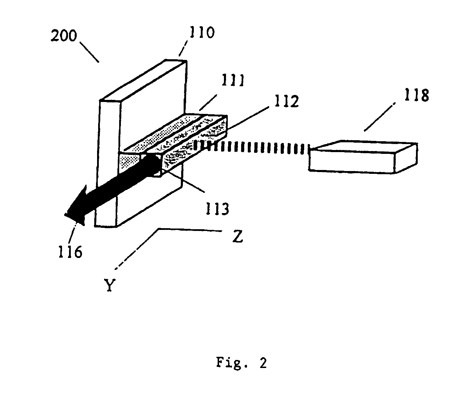

Fig. 2 shows an embodiment 200 of an optically-pumped laser in accordance with the present invention in which it is not necessary to form stripe 115 on layer 112. In this embodiment, the cladding layer 111 forms a ridge on the first mirror layer 110 on which the layer 112 of organic material is deposited. In this embodiment, the optical mode is thus confined in both the z- and y-directions. The width of the layers 111 and 112 should preferably be narrow enough to support only a single lateral optical mode (e.g., 1-10 µm). The thickness of the active organic layer 112 should be approximately equal to the reciprocal of the absorption coefficient of the host material at the wavelength of the light with which the device is pumped. If a reflective layer (not shown) is placed between the layer 111 and the first mirror layer 110, the thickness of the organic layer 112 should be approximately half the reciprocal of the absorption coefficient of the host material at the wavelength of the light with which the device is pumped. To protect the laser device of Fig. 2, it is optionally overcoated with a transparent material (not shown) whose index of refraction is lower than that of the layer 112.

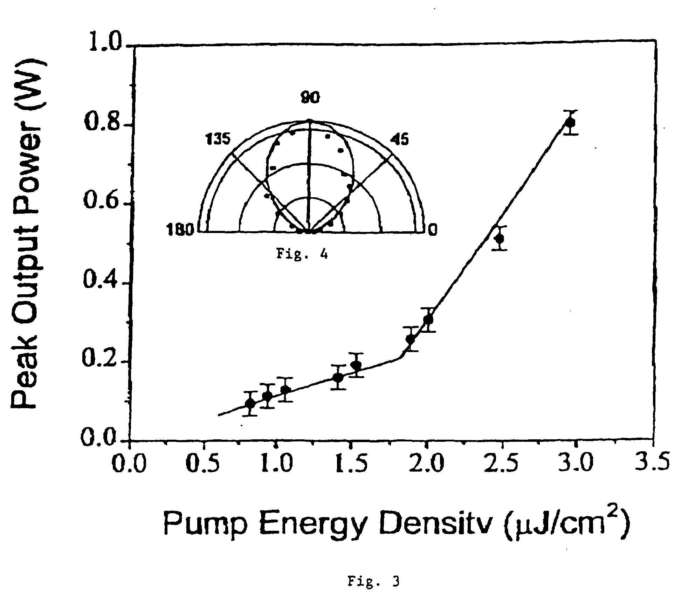

An example of the dependence of the peak output power of the device 100 to the pump energy density is shown in Fig. 3. From this relationship, the lasing threshold is clearly discerned. Each line segment in the graph of Fig. 3 is a linear fit to empirically measured points. The slopes of the two line segments emphasize a change in differential quantum efficiency, from 0.2% (below the lasing threshold) to 10% (above the lasing threshold). It is to be noted, however, that measured differential quantum efficiencies represent a considerable underestimation since the lasing region in an optically pumped gain-guided device is only a small fraction of the material which is being pumped. Hence, most of the pump power is lost in non-lasing regions. The differential quantum efficiency decreases to 7% at excitation levels above 10 J/cm² (not shown), corresponding to peak output powers exceeding 4 W.

Fig. 4 (inset to Fig. 3) shows the intensity of the emission from device 100 as passing through a polarizer as a function of angle between the plane orthogonal to the film surface and the plane of the polarizer. The emission is strongly linearly polarized, as is expected for laser emission. The degree of polarization measured is 15 dB; although it should be noted that this result is limited by the measurement arrangement. The solid line, which is a fit of the empirically measured points, follows sin² α, where is the polarizer angle.

In addition to the optically-pumped embodiments discussed above, the present invention also provides electrically-pumped organic semiconductor laser embodiments. Such embodiments make use of electroluminescent materials that emit light when excited by electric current.

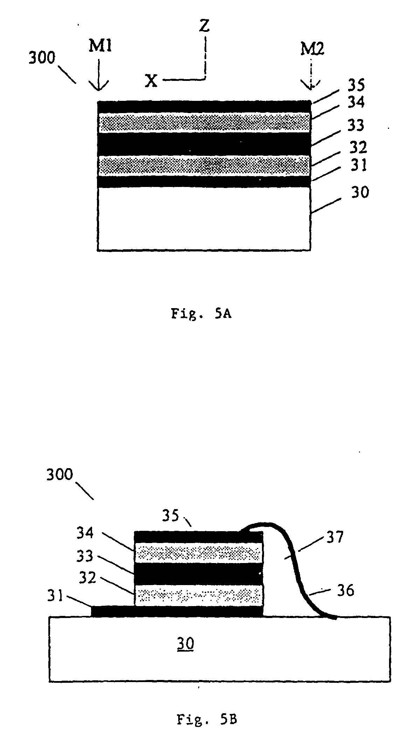

Fig. 5a shows a cross-sectional view of an electrically-pumped laser device embodiment of the present invention. Device 300 includes a first electrode 31, a bottom cladding layer 32, a layer 33 of active organic material, a top cladding layer 34 and a second electrode 35, which are deposited in sequence over a first mirror layer 30. The degree of optical confinement in the active layer 33 depends on factors such as the indices of refraction of the cladding layers 32 and 34.

The layer 33 of active organic material comprises any suitable organic electroluminescent material, such as doped Alq₃. Either one of the cladding layers 32, 34 is composed of a hole conducting material, such as MgF₂ doped with 10% of TPD. The other one of the cladding layers is composed of an electron conducting material, such as Alq₃ or MgF₂ doped with Alq₃. For either cladding layer 32 or 34, the MgF₂ can be replaced with another alkali halide such as LiF, KF or KI or with a transparent, low index of refraction, conducting organic material. Upon passing a current between electrodes 31 and 35, electrons and holes are injected into the active layer 33 where the energy is transferred from the conducting host material to the dopant materials, which emit light.

An optical resonator is formed by the edges of the device 300, i.e., mirror facets M1 and M2. At least one of the electrodes 31 and 35 is patterned into a stripe oriented in the x-direction. That portion of the active material which is electrically pumped experiences a change in optical gain, thus forming a waveguide in the lateral direction (i.e., the gain-guiding effect).

In the electrically-pumped laser device shown in Fig. 5a, the index of refraction of the active layer 33 is preferably higher than that of the cladding layers 32 and 34. This ensures that most of the mode overlaps with the gain layer. Preferably, the indices of refraction of the cladding layers 32 and 34 should be substantially equal to provide optimal optical confinement within layer 33.

The cladding layers 32 and 34 should be thick enough to substantially prevent absorption of the optical mode at the electrodes 31 and 35 and to allow for efficient current injection. For single-mode operation, the thickness of the active layer 33 should be substantially equal to the lasing wavelength divided by twice the index of refraction of the active layer. For higher modes, the thickness of the active layer 33 should be accordingly greater.

Optical confinement in layer 33 is also achieved, for example, by photo-bleaching the layer 33 to define a waveguide therein. Using this technique, once the active layer 33 has been deposited, a photomask is applied which partially covers the active layer 33 and the layer is exposed to intense UV light in an O₂ environment. The unmasked portions of the active layer 33 are thus bleached, lowering their index of refraction. The masked portion of the active layer 33 retains its original, higher index of refraction and thus results in optical confinement therein.

As another example, optical confinement is achieved by patterning the first mirror layer or bottom cladding layer to achieve index guiding. For example, photo-bleaching can be used on the bottom cladding layer 32 to create an index modulated distributed Bragg reflector under the active layer 33.

An optical resonator is optionally formed in the z-direction. In this case, the top and first electrodes also serve as optical mirrors, or, if the electrodes are transparent to light, high reflectivity mirrors are added on both sides of the structure. The maximum of the optical mode of this structure should spatially match the position of the optical layer. Furthermore, the wavelength of the optical mode should overlap with the gain spectrum of the dopant material.

Fig. 5b shows a further embodiment of an electrically-pumped laser device in accordance with the present invention. In this embodiment, the first electrode 31 extends beyond the laser structure so as to provide a contact surface. Additionally, an insulator 37 is provided on a side of the laser structure and a contact 36 extending from the second electrode 35 to the surface of the first mirror layer 30 is deposited on the insulator.

The present invention includes organic vertical-cavity surface-emitting laser (OVCSEL) structures, in which laser cavities are used to produce a clear threshold in output power, a well-defined laser beam, cavity modes, and spectral line narrowing of emission above threshold to less than 1 . The high gain in these films is sufficient to generate lasing even in cavities with active regions less than 500 nm thick, thereby minimizing the amount of active organic material required for operation.

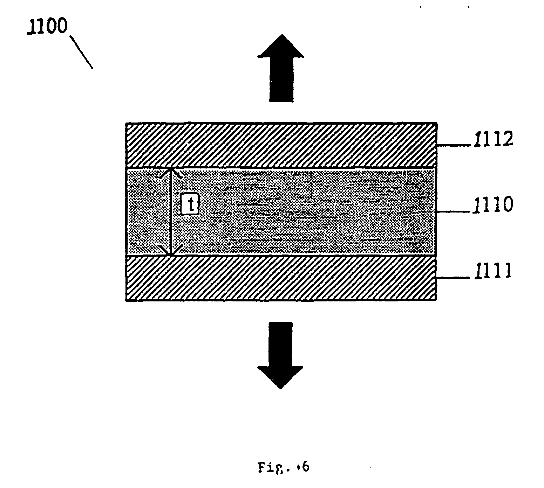

Fig. 6 shows a cross-section of a laser cavity structure 1100 in accordance with an embodiment of the present invention. In this structure, an active organic material layer 1110 is disposed between a first mirror layer 1111 and a second mirror layer 1112 to thereby form a cavity of thickness, t. The organic material in layer 1110 is "active" in that it lases when pumped by optical or electrical means to thereby produce laser light. The first and second mirror layers 1111, 1112 each reflect a substantial amount of the light produced by the layer 1110 so that only coherent laser light passes through layers 1111, 1112, the laser light having a desired wavelength and characterized by a narrow bandwidth. The first and second mirror layers 1111, 1112 each preferably reflect at least 90%, more preferably 95%, and most preferably 98%, of the light produced by the pumping of layer 1110. If the first and second mirror layers 1111, 1112 reflect substantially the same percentage of light emitted from layer 1110, the passage of light through both first and second mirror layers 1111, 1112 will be substantially equal, as shown in Fig. 6. If, for example, the second mirror layer 1112 reflects a greater percentage of light than first mirror layer 1111, however, then the passage of light will be primarily through the first mirror layer 1111 provided that the absorption characteristics of the first and second mirror layers are equal.

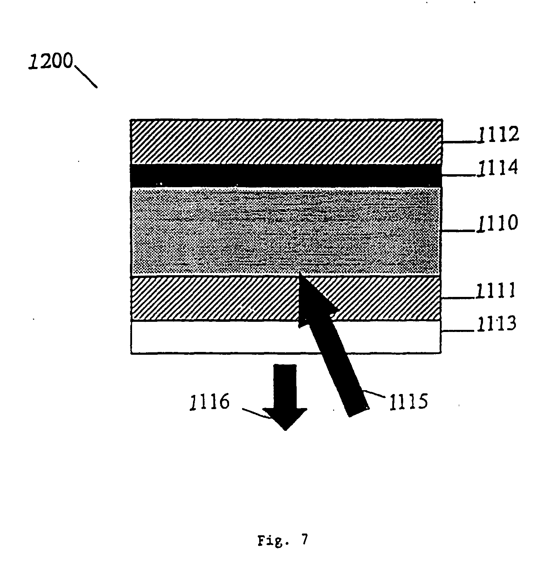

Fig. 7 shows an optically-pumped OVCSEL structure 1200, in accordance with an embodiment of the present invention. A first mirror layer 1111, a layer of active organic material 1110 and a second mirror layer 1112 are disposed on a substantially transparent substrate 1113. The layer of active organic material 1110 is pumped by incident optical pump energy 1115. The source of optical pump energy (not shown) is any suitable source of intense light, such as a nitrogen laser.

The first and second mirror layers 1111, 1112, are any suitable reflective materials or structures. A preferred structure for the first mirror layer 1111 is a distributed Bragg reflector ("DBR") dielectric mirror stack. DBR mirrors are commercially available and consist of **λ**/4 thick dielectric layers, where represents the wavelength of the DBR mirror reflective stopband. DBR mirrors thus render the ability to control the OVCSEL output spectrum, which in turn narrows the linewidth of such output. DBR mirrors are typically characterized by reflectivities in excess of 99%. The second mirror 1112 is preferably a DBR mirror or a layer of reflective metal or alloy such as silver, platinum, aluminum, magnesium-aluminum alloy, or combinations thereof. Metal mirrors typically have reflectivities in excess of 90%, but absorb more light than do DBR mirrors. When the second mirror 1112 comprises a metal, the OVCSEL structure 1200 preferably includes an organic buffer layer 1114 to reduce quenching of the organic material in the layer 1110 at the organic / metal interface with the layer 1112. In the embodiment shown in Fig. 7, the combined reflectivity and absorption of the second mirror layer 1112 is greater than that of the first mirror layer 1111, thus resulting in laser emission 1116 through the first mirror layer 1111.

The substrate 1113 is any suitable transparent substrate such as quartz, glass, sapphire or plastic. The substrate 1113 is limited to those materials which are transparent to the wavelengths of incident optical pumping energy and of laser light produced by layer 1110.

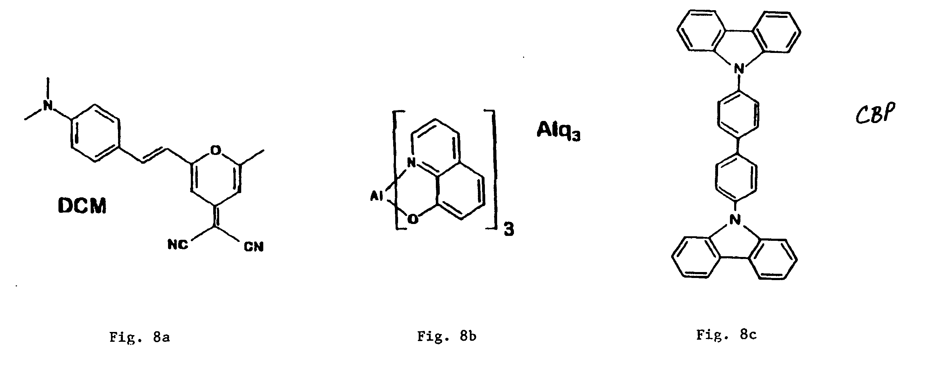

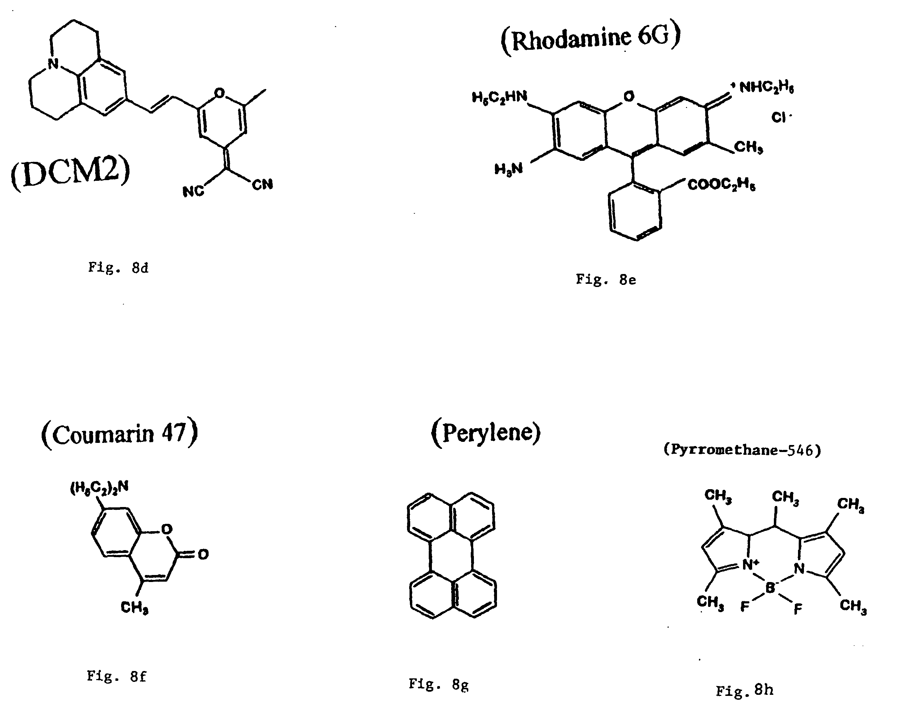

In all embodiments of the present invention, the active organic material comprises host and dopant molecules. The pump energy imparted to layer 1110 is absorbed by the host molecule and is non-radiatively transferred by a dipole-dipole transition to the dopant molecule. For this to occur, the emission spectrum of the host should overlap with the absorption spectrum of the dopant. The resulting efficient "Förster" energy transfer requires only a low concentration of dopant molecules, which in turn reduces the lasing threshold, increases laser efficiency, and extends operational lifetime. The host materials used in the present invention are selected from any materials that provide good charge transport and are able to transfer energy to a dopant material via Förster energy transfer or carrier capture. In addition, the rate of energy transfer to the dopant must be faster than the non-radiative recombination in the host. The dopant materials used in the present invention are any highly efficient luminescent molecules having luminescence (lasing) emission in the same spectral range as the transparency region of the host:dopant system. Exemplary host-dopant systems for use as the active organic material in the present invention, and some of their associated lasing characteristics are set forth in Table I. The formulae for the chemicals known as DCM (Exciton Inc. of Dayton, Ohio), Alq₃, CBP, DCM2 (Exciton Inc. of Dayton, Ohio), rhodamine-6G, coumarin-47, perylene, and pyrromethane-546 are shown in Figs. 8A-8H, respectively. The organic materials used in the present invention are deposited by any suitable technique, such as by vacuum thermal evaporation.

**Table I.**

| Exemplary active organic materials for use in the OVCSELs of the present invention. | | | | |
|---|---|---|---|---|
| Host | Dopant | Lasing Wavelength (nm) | Lasing Threshold (µJ/cm²) | -Operating Lifetime (# of pump laser pulses) |
| Alq₃ | DCM | 615-660 | 3 | >10⁶ |
| Alq₃ | DCM2 | 655-700 | 2.5 | >10⁶ |
| Alq₃ | rhodamine-6G | 610-625 | 30 | 10³ |
| Alq₃ | pyrromethane-546 | 560 | 15 | >10⁵ |
| CBP | perylene | 485 | 5 | >10⁵ |
| CBP | coumarin-47 | 460 | 15 | 10³ |
| CBP | coumarin-30 | 510 | 15 | -- |

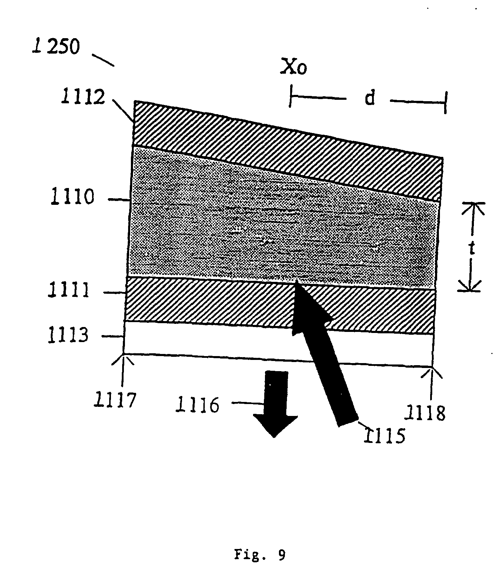

The present invention includes embodiments in which the laser emission is tunable to a specific wavelength. Fig. 9 shows an example of an optically-pumped, tunable OVCSEL 1250 in accordance with an embodiment of the present invention. In this embodiment, the thickness, t, of the layer 1110 of active organic material changes monotonically from the left edge 1117 to the right edge 1118 of the structure. In an alternative embodiment, the thickness of the layer 1110 changes in a stepwise fashion for the emission of discrete wavelengths. By changing the thickness of the OVCSEL cavity, the emission wavelength is tunable by as much as 50 nm or more, due to the wide gain spectrum of the lasing material in layer 1110. Such thickness variation is achieved, for example, by masking the substrate with a sliding shadow mask during growth of layer 1110. Alternatively, an effective thickness variation is achieved by tilting the substrate with respect to a pump beam source. The tunable OVCSEL is pumped by a pump beam 1115, which excites the active organic material of layer 1110 at a point Xo, which is at a distance d away from the right edge 1118. The wavelength of laser emission 1116 is a function of the cavity thickness t and the index of the organic material in layer 1110. By changing the position of point Xo, a different section of the OVCSEL structure 1250 (having a different thickness, t) is excited by pump beam 1115, thus resulting in a different wavelength of emission 1116. Changing the position of Xo by varying d is accomplished by, for example, moving the OVCSEL structure 1250, moving the position or angle of the pump beam 1115, or both. As an example, the inventors have changed the laser emission of an optically-pumped Alq₃:DCM laser of the present invention from 598 to 635 nm by changing the thickness of layer 1110 from 430 to 500 nm.

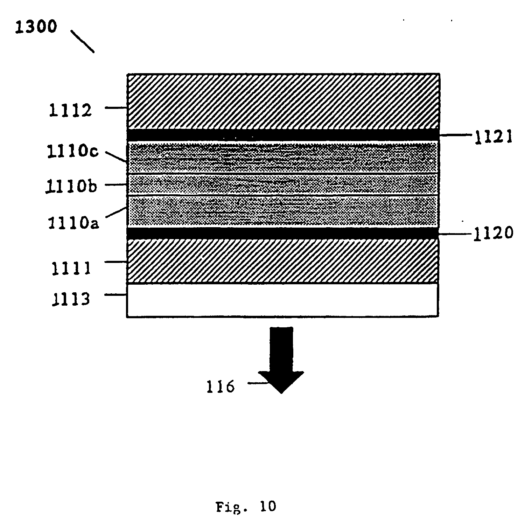

Fig. 10 shows an electrically-pumped OVCSEL structure 1300, in accordance with an embodiment of the present invention. A first mirror layer 1111, a layer of active organic material 1110 (comprising sub-layers 1110a, 1110b and 1110c) and a second mirror layer 1112 are disposed on a substantially transparent substrate 1113. If the first and second mirror layers 1111, 1112 are not able to function as electrodes, or alternatively-if it is preferable to have separate electrodes, a first electrode 1120 is disposed between the first mirror layer 1111 and the layer of active organic material 1110, and a second electrode 1121 is disposed between the layer of active organic material 1110 and the second mirror layer 1112. In this embodiment, the organic material in layer 1110 is electroluminescent such that it is pumped to produce laser light when an electric current is passed therethrough. As is known in the art, the organic material in the layer 1110 (and in all other electrically-pumped embodiments of the present invention) typically consists of three sub-layers: a hole transporting layer ("HTL") 1110a, an emissive layer ("EL") 1110b, and an electron transporting layer ("ETL") 1110c. First and second electrodes 1120, 1121 (in the embodiment shown in Fig. 10, first and second electrodes are anode and cathode, respectively) are substantially transparent to the light emitted by layer 1110b, and preferably comprise indium-tin-oxide or any other transparent conducting material.

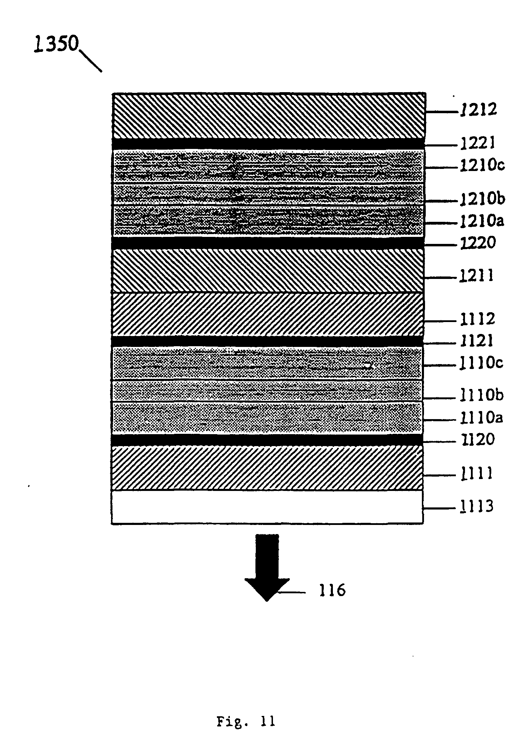

In one embodiment of the present invention, multiple electrically-pumped OVCSEL structures are placed in a stacked arrangement 1350, as shown in Fig. 11, for the emission of laser light of various colors. The stacked arrangement 1350 includes the structure 1300 as shown in Fig. 10, but also includes a third mirror layer 1211, a third electrode 1220, sublayers 1210a, 1210b, and 1210c (corresponding to HTL, EL and ETL layers, respectively) of a second active organic material, a fourth electrode 1221, and a fourth mirror layer 1212 as shown in Fig. 11. As in the OVCSEL structure 1300, the electrodes 1120, 1121, 1220 and 1221 are only necessary in the stacked arrangement 1350 if the respective mirror structures 1111, 1112, 1211 and 1212 cannot function as electrodes, or alternatively if it is preferable to have electrodes separate from the mirror structures. Although only two OVCSEL structures are shown in the stacked arrangement 1350, the present invention includes embodiments in which three or more OVCSEL structures are stacked in a unitary structure. The stacking of OVCSEL structures facilitates the lasing of multiple colors, each from a respective OVSEL, alone or in any combination.

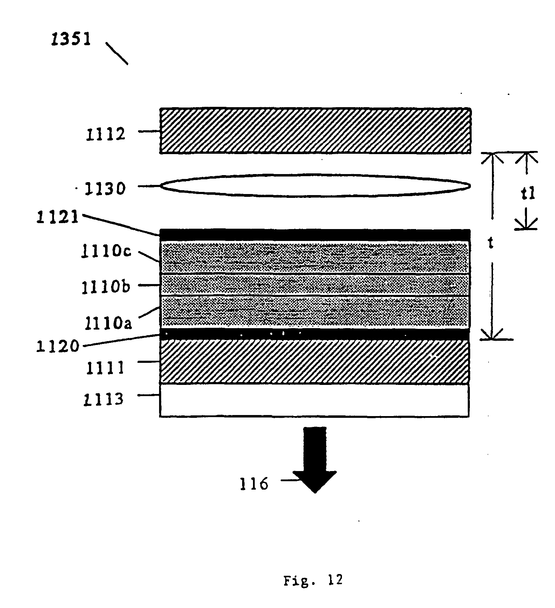

The present invention includes electrically-pumped OVCSELs that are tunable to specific wavelengths. Fig. 12 shows an example of such a tunable OVCSEL 1351 in accordance with an embodiment of the present invention. As described for the optically-pumped tunable OVCSEL 1250, the laser emission wavelength of OVCSEL 1351 is tunable by varying the thickness t of the OVCSEL cavity. The variation in t is accomplished by controlling the distance t1 between the second electrode 1121 and the second mirror layer 1112. The distance t1 is varied by the controlled movement of the second mirror layer 1112 towards or away from the second electrode 1121, or vice-versa. Optical lens 1130 is disposed between the second electrode 1121 and the second mirror layer 1112 to permit the variation in t1 without losing control of the laser light emitted from layer 1110b.

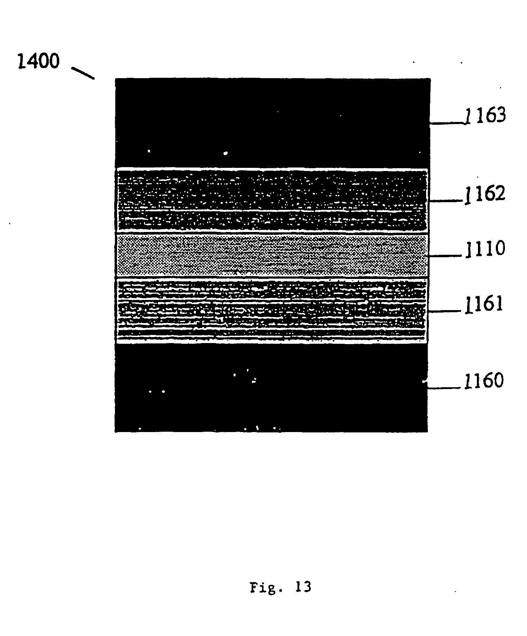

All embodiments of the present invention optionally include guiding and cladding layers around the organic layers to help minimize waveguiding losses in the organic layers. For example, waveguide optical losses in organic layers of thickness 150 nm are often as high as 1000 cm⁻¹ or more where metal electrodes are used in electroluminescent devices. A structure 1400 as shown in Fig. 13 is used to minimize such losses. Structure 1400 includes guiding layers 1161 and 1162 immediately adjacent to the organic layer(s) 1110, and cladding layers 1160 and 1163 immediately adjacent to the guiding layers 1161 and 1162, respectively. As is known in the art and previously discussed, if layer 1110 comprises an electroluminescent material, it may actually comprises multiple sublayers (i.e., HTL, EL and ETL layers). The guiding layers 1161, 1162 are highly transparent to minimize optical losses, and are characterized by a high refractive index. The cladding layers 1160, 1163 are also transparent but possess a lower refractive index than the guiding-layers 1161, 1162. The cladding layers 1160, 1163 also generally have higher conductivities than the guiding layers 1161, 1162, as one of the primary purposes of cladding layers 1160, 1163 is to conduct electrical current. The structure 1400 reduces the confinement of emitted light in organic layer(s) 1110, thus reducing optical losses to as low as 10 cm⁻¹ or less. The structure 1400 is optionally used with any of the optically- or electrically-pumped embodiments of the present invention. For example, when used with the optically-pumped embodiment 1200 of the present invention, the structure 1400 is substituted for the layer of active organic material 1110 in Fig. 7. Likewise, when used with the electrically-pumped embodiment 1300, the structure 1400 is substituted for the sublayers 1110a, 1110b and 1110c such that the structure 1400 is sandwiched by the electrodes 1120 and 1121. When used with the electrically-pumped embodiment, the guiding and cladding layers 1160, 1161, 1162, 1163 must be sufficiently conductive to provide charge carriers to the conductive layer(s) 1110 from the electrodes 1120, 1121. It is preferred, however, that the conductivity of guiding layers 1161, 1162 is less than that of cladding layers 1160, 1163, which have a conductivity less than that of the surrounding electrodes 1120, 1121. The preferred material for the guiding and cladding layers 1160, 1161, 1162, 1163 is indium-tin-oxide, the refractive index, conductivity and transparency of which is varied, for example, by varying oxygen content.

The present invention is further described with reference to the following non-limiting examples.

### Example 1

A laser device as shown in Fig. 1 was formed. Alq₃ and DCM (molecular ratio of approximately 50:1) were co-evaporated under a high vacuum (5x10⁻⁷ Torr; 1 Torr ≃ 1,33 Pa) onto a glass slide. The resulting 3000 thick layer 112 of Alq₃ / DCM, having an index of refraction (n) of 1.7, forms a slab optical waveguide with glass (n=1.4) as a cladding layer on one side, and air (n=1) on the other. This slab optical waveguide in conjunction with the reflective facets 113, 114 of the layer 112 form an optical resonator.

A nitrogen laser 118 operating at 500 psec pulses with a wavelength of 337 nm at a 50 Hz repetition rate was used to generate the optical pump beam. Lateral confinement of the optical mode was achieved by gain-guiding induced by the optical pump beam. Bright red laser emission was clearly visible from the edge 113. Diffraction of the output beam was faintly observed. The output laser beam included several transverse modes which diverged in the direction orthogonal to the device surface. The peak intensity of the red laser emission at the output facets is 10⁸ W/cm² (corresponding to a measured peak power exceeding 30W) at a pump level of 200µJ/cm². No degradation of the Alq₃ / DCM film was observed after several hours of operation (which corresponds to at least 10⁶ laser pulses. This indicates that Alq₃ / DCM films enjoy a high degree of photochemical stability and are well-suited for use in electrically-pumped organic lasers.

### Example 2

A laser was formed by vacuum-depositing a 120 nm organic film containing perylene-doped CBP onto the (100) crystallographic surface of a polished InP first mirror layer. The first mirror layer was pre-coated with a 2 µm layer of SiO₂, deposited by plasma enhanced chemical vapor deposition. The laser was optically pumped with 500 psec pulses generated by a nitrogen laser at λ= 337 nm, with a 50 Hz repetition rate. The pump beam was focused onto a 50 µm width region on the organic film to form the gain region.

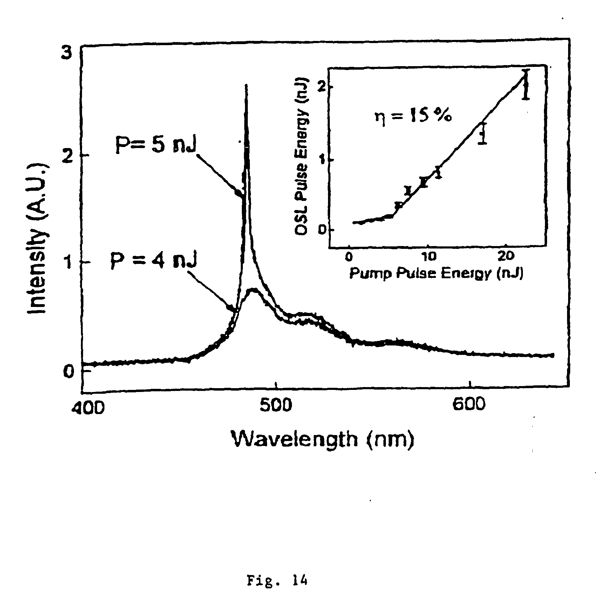

Fig. 14 shows the edge emission spectra of the optically-pumped laser at pump levels below (4 nJ) and just above the threshold (5 nJ). Lasing appears as a spectrally narrow (2 nm, FWHM) peak at λ= 485 nm. The inset in Fig. 14 shows the output pulse energy of the laser as a function of pump pulse energy, clearly indicating the presence of a lasing threshold at a pump pulse energy of 5 nJ (which corresponds to an energy density of 5 µJ/cm². Moreover, the laser exhibited an operational lifetime in excess of 10⁵ laser pulses.

### Example 3

A laser was formed by vacuum-depositing an organic film containing coumarin-47-doped CBP onto the (100) crystallographic surface of a polished InP first mirror layer. The first mirror layer was pre-coated with a 2 µm layer of SiO₂, deposited by plasma enhanced chemical vapor depsition. The laser was optically pumped with 500 psec pulses generated by a nitrogen laser at λ= 337 nm, with a 50 Hz repetition rate. The pump beam was focused onto a 50 µm width region on the organic film to form the gain region.

The optically-pumped laser resulted in a lasing wavelength of approximately 455 nm and a lasing threshold of 15 µJ/cm². Moreover, the laser exhibited an operational lifetime on the order of 10³ laser pulses.

### Example 4

A laser was formed by vacuum-depositing an organic film containing coumarin-30-doped CBP onto the (100) crystallographic surface of a polished InP first mirror layer. The first mirror layer was pre-coated with a 2 µm layer of SiO₂, deposited by plasma enhanced chemical vapor depsition. The laser was optically pumped with 500 psec pulses generated by a nitrogen laser at λ= 337 nm, with a 50 Hz repetition rate. The pump beam was focused onto a 50 µm width region on the organic film to form the gain region.

The optically-pumped laser resulted in a lasing wavelength of approximately 510 nm and a lasing threshold of 13 µJ/cm². Moreover, the laser exhibited an operational lifetime on the order of 10² laser pulses.

### Example 5

A laser was formed by vacuum-depositing an organic film containing DCM2-doped Alq₃ onto a polished InP first mirror layer. The first mirror layer was pre-coated with a 2µm layer of SiO₂, deposited by plasma enhanced chemical vapor deposition. The laser was optically pumped with 500 psec pulses generated by a nitrogen laser at λ= 337nm, with a 50 Hz repetition rate.

The optically-pumped laser resulted in a lasing wavelength of approximately 670 nm and a lasing threshold of 2.5 µJ/cm². Moreover, the laser exhibited an operational lifetime in excess of 10⁶ laser pulses and a differential quantum efficiency of approximately 30%.

### Example 6

A laser was formed by vacuum-depositing an organic film containing DCM-doped Alq₃ onto a polished InP first mirror layer. The first mirror layer was pre-coated with a 2µm layer of SiO₂, deposited by plasma enhanced chemical vapor deposition. The laser was optically pumped with 500 psec pulses generated by a nitrogen laser at λ= 33.7nm, with a 50 Hz repetition rate.

The optically-pumped laser resulted in a lasing wavelength of approximately 650 nm and a lasing threshold of approximately 3 µJ/cm². Moreover, the laser exhibited an operational lifetime in excess of 10⁶ laser pulses and a differential quantum efficiency of approximately 30%.

### Example 7

As one example of the embodiment shown in Fig. 7, an OVCSEL 1200 was formed comprising an active layer 1110 of tris-(8-hydroxyquinoline) aluminum ("Alq₃") doped with DCM laser dye. The thickness of the active layer 1110 was 500 nm. The concentration of DCM laser dye in the layer 1110 was 3% by weight. The active layer 1110 was deposited onto the first mirror layer 1111 (a DBR mirror in this example) by thermal evaporation at 5 x 10⁻⁷ Torr. The buffer layer 1114 comprised Alq₃ and was deposited over the active layer 1110, and a silver mirror layer 1112 was deposited over the buffer layer 1114. The thicknesses of the buffer layer 1114 and the DBR mirror layer 1111 were 20 nm and 200 nm, respectively. The DBR mirror layer 1111 had a >99% reflective stopband between 600 nm and 700 nm, while the reflectivity of the silver mirror was calculated to be 91%.

The OVCSEL 1200 was optically pumped using a nitrogen laser (λ= 337 nm), which generated 500 ps pulses at a 50 Hz repetition rate. The pump beam was aimed incident through the DBR mirror 1111 and was focused to a spot approximately 100 m across on the organic film surface. At the wavelength of the exciting laser (i.e., λ= 337 nm) the DBR mirror 1111 exhibited a transmittance of about 80%. In this example, the substrate 1113 comprised quartz, which is transparent to a pump beam characterized by λ= 337 nm.

The emission spectrum in the substrate normal direction (with a 15 full angle acceptance cone) was analyzed by a spectrograph using a charge-coupled device camera with a wavelength resolution of 0,1 nm. To avoid material degradation, all measurements were performed in a dry nitrogen environment.

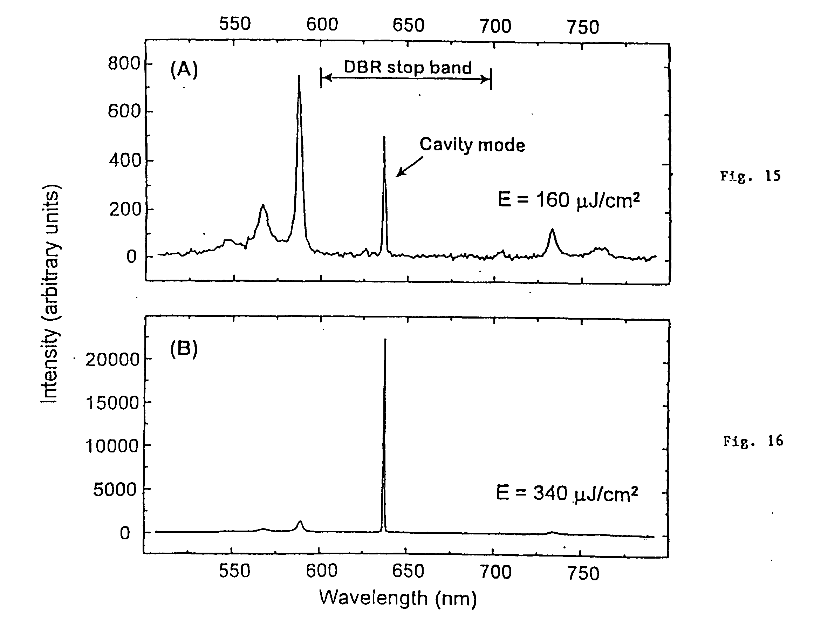

Fig. 15 shows the spontaneous emission spectrum of the OVCSEL 1200 just below the lasing threshold. A cavity mode was observed at λ= 635 nm. At λ < 600 nm and λ > 700 nm, the spontaneous emission is filtered by the modulation in the DBR transmission spectrum resulting in the broad satellite peaks observed. The spectrum above the lasing threshold, corresponding to an energy of E_{TH} = 300 J/cm², is completely dominated by the high gain, spectrally narrow laser emission, as shown in Fig. 16.

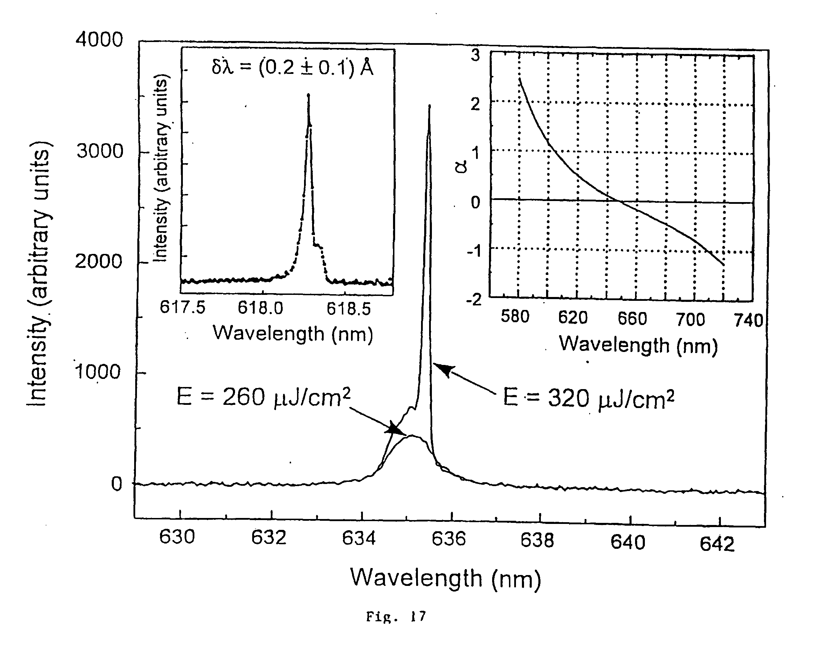

Fig. 17 shows the high resolution emission spectra from the OVCSEL 1200 at increasing excitation levels near the lasing threshold. Pump energies and the spectral full width at half maximum are indicated. The transition from the 1,2 nm wide spontaneous emission peak, spectrally filtered by the microcavity below threshold, to the resolution-limited, < 0,1 nm full width spectral line due to laser emission above threshold, is clearly observed. The spectral width of the peak below threshold is related to the finesse (the ratio of microcavity mode spacing to a single mode linewidth) of the microcavity, with additional broadening due to the presence of several transverse modes. Mode competition above threshold confines lasing to only a few of the transverse modes, leading to a concomitant reduction in the emission linewidth. The left inset of Fig. 17 shows (0.4 ± 0.1) broad emission line of an OVSEL with a cavity thickness of 475 nm. Accounting for the (0.2 ± 0.1) instrument resolution, the Gaussian full-width-at-half-maximum of the lasing line is calculated to be (0.2 ± 0.1).

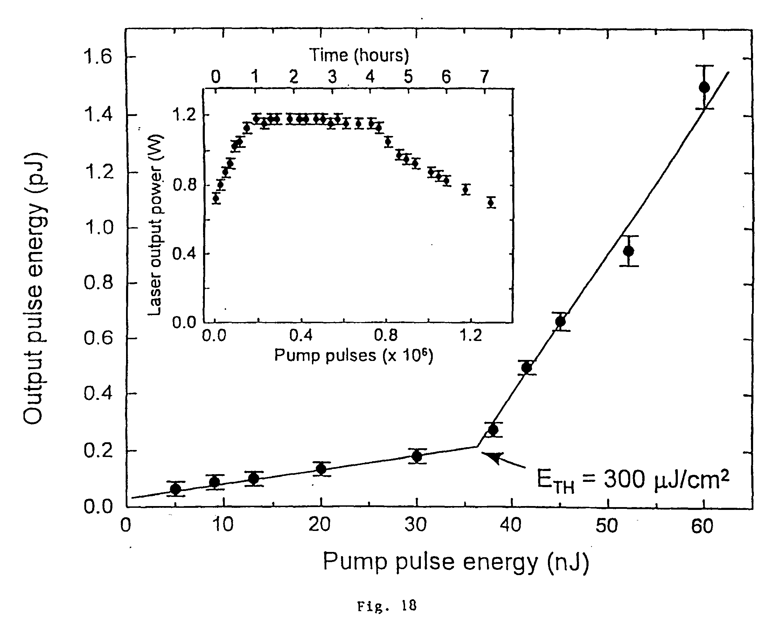

Fig. 18 shows the dependence of the laser output power on input excitation, clearly indicating a threshold at a pump energy density of E_{TH} = 300 J/cm². This threshold is two orders of magnitude higher than that for similar edge emitting organic semiconductor lasers as a consequence of higher optical losses in the microcavity structure (500 cm⁻¹), and a short gain length (500 nm). The Alq₃:DCM material gain at threshold in OVCSELs is estimated to be g_{TH} = 500 cm⁻¹, which is comparable to the internal gain in InGaAs/GaAs quantum well structures.

The lasers of the present invention are applicable to a wide variety of applications, including telecommunications, printing, optical downconversion, semiconductor circuit etching, thermal processing (e.g., marking, soldering and welding), spectroscopy, vehicular control and navigation, measurement devices, optical memory devices, displays, scanners, pointers, games and entertainment systems and sensors.

The present invention provides for organic lasers with desired properties such as narrow bandwidth emission, the minimal use of active organic materials, and the facilitation of wavelength tuning and electrical pumping. The vertical-cavity surface-emitting structures of the present invention represent the first known successful demonstration of lasing action in a small molecular weight organic semiconductor microcavity structure associated with a clear threshold in the output power, a well defined laser beam, cavity modes, and spectral line narrowing of emission above threshold to less than 0.1 nm. Those with skill in the art may recognize various modifications to the embodiments of the invention described and illustrated herein. Such modifications are meant to be covered by the appended claims.

## Claims

1. An organic laser comprising:
- a first mirror layer (110), not being a substrate;
- a layer (112) of first active organic material over said first mirror layer (110), wherein said first active organic material includes two reflective facets (113, 114) that are substantially parallel to each other thereby forming an optical resonator in the layer (112) of first active organic material; and
- a pumping means (118); wherein
- said first active organic material lases when pumped by said pumping means (118) to thereby produce laser light (116); and
- said first mirror layer (110) is capable of reflecting at least a portion of the light produced by said first active organic material.

2. The laser of claim 1, wherein said first mirror layer (110) has an index of refraction less than an index of refraction of the first active organic material.

3. The laser of claim 1, wherein said first mirror layer (110) comprises a distributed Bragg reflector dielectric mirror stack.

4. The laser of claim 1, wherein said first mirror layer (110) comprises InP.

5. The laser of claim 4, wherein said first active organic material is deposited onto the (100) crystallographic plane of said InP.

6. The laser of claim 1, further comprising a cladding layer (111) between said first mirror layer (110) and said layer (112) of first active organic material, said cladding layer (111) comprising a material having an index of refraction less than said first active organic material.

7. The laser of claim 6, wherein said cladding layer (111) comprises silicon dioxide.

8. The laser of claim 1, wherein said layer (112) of first active organic material comprises a host organic material doped with a dopant material.

9. The laser of claim 8, wherein said host organic material is selected from the group consisting of tris(8-hydroxyquinoline) aluminium, CBP, and combinations thereof.

10. The laser of claim 9, wherein said dopant material is selected from the group consisting of rhodamine-6G, DCM, DCM2, coumarin-30, coumarin-47, perylene, pyrromethane-546, and combinations thereof.

11. The laser of claim 10, wherein an electroluminescent spectrum of the host material and an absorption spectrum of the dopant material overlap.

12. The laser of claim 1, wherein said pumping means (118) comprises a source of optical pump energy for pumping said first active organic material.

13. The laser of claim 12, wherein said optical pump energy comprises a nitrogen laser.

14. The laser of claim 12, wherein:
said layer (112) of first active organic material varies in thickness; and
the wavelength of the laser light produced by the pumping of said first active organic material is a function of the thickness of said layer (112) of first active organic material at the location where said optical pump energy pumps said layer (112) of first active organic material.

15. A device including the laser of claim 1, said device selected from the group consisting of a telecommunications device, a printing device, an optical device, a semiconductor circuit etching device, a thermal processing device, a spectroscopy device, a vehicular control device, a vehicular navigation device, a measurement device, an optical memory device, a display, a scanner, a pointer, a game, an entertainment system, and a sensor.

## Patentansprüche

1. Ein organischer Laser, umfassend:
- eine erste Spiegelschicht (110), die kein Substrat ist,
- eine Schicht (112) eines ersten aktiven organischen Materials über der ersten Spiegelschicht (110), wobei das erste aktive organische Material zwei reflektierende Facetten (113, 114) einschließt, die im Wesentlichen parallel zueinander angeordnet sind und auf diese Weise einen optischen Resonator in der Schicht (112) des ersten aktiven organischen Materials bilden, und
- eine Pumpeinrichtung (118), wobei
- das erste aktive organische Material Laserstrahlung abgibt, wenn es durch die Pumpeinrichtung (118) zur Erzeugung von Laserlicht (116) angeregt wird, und
- die erste Spiegelschicht (110) wenigstens einen Teil des durch das erste aktive organische Material erzeugten Lichts reflektieren kann.

2. Ein Laser nach Anspruch 1, **dadurch gekennzeichnet, dass** die erste Spiegelschicht (110) einen Brechungsindex hat, der kleiner als der Brechungsindex des ersten aktiven organischen Materials ist.

3. Laser nach Anspruch 1, **dadurch gekennzeichnet, dass** die erste Spiegelschicht (110) einen Stapel von dielektrischen DBR(distributed Bregg reflector)-Spiegeln umfasst.

4. Laser nach Anspruch 1, **dadurch gekennzeichnet, dass** die erste Spiegelschicht (110) lnP umfasst.

5. Laser nach Anspruch 4, **dadurch gekennzeichnet, dass** das erste organische Material auf der (100) kristallographischen Ebene des InP aufgebracht ist.

6. Laser nach Anspruch 1, **dadurch gekennzeichnet, dass** er eine Umhüllungsschicht (111) zwischen der ersten Spiegelschicht (110) und der Schicht (112) des ersten aktiven organischen Materials umfasst, wobei die Umhüllungsschicht (111) ein Material mit einem Brechungsindex umfasst, der kleiner als der Brechungsindex des ersten aktiven organischen Materials ist.

7. Laser nach Anspruch 6, **dadurch gekennzeichnet, dass** die Umhüllungsschicht (111) Silikondioxid umfasst.

8. Laser nach Anspruch 1, **dadurch gekennzeichnet, dass** die Schicht (112) des ersten aktiven organischen Materials ein organisches Hostmaterial umfasst, das mit einem Dopantmaterial beschichtet ist.

9. Laser nach Anspruch 8, **dadurch gekennzeichnet, dass** das organische Hostmaterial aus der Gruppe von Tris(8-Hydroxyquinolin)Aluminium, CBP sowie Kombinationen davon ausgewählt ist.

10. Laser nach Anspruch 9, **dadurch gekennzeichnet, dass** das Dopantmaterial aus der Gruppe von Rhodamin-6G, DCM, DCM2, Coumarin-30, Coumarin-47, Perylen, Pyrromethen-546 sowie Kombinationen davon ausgewählt ist.

11. Laser nach Anspruch 10, **dadurch gekennzeichnet, dass** das elektrolumineszierende Spektrum des Hostmaterials und das Absorptionsspektrum des Dopantmaterials sich überlappen.

12. Laser nach Anspruch 1, **dadurch gekennzeichnet, dass** die Pumpeinrichtung (118) eine Quelle für optische Pumpenergie umfasst, um das erste aktive organische Material anzuregen.

13. Laser nach Anspruch 12, **dadurch gekennzeichnet, dass** die Quelle optischer Pumpenergie einen Nitrogenlaser umfasst.

14. Laser nach Anspruch 12, **dadurch gekennzeichnet, dass** die Schicht (112) des ersten aktiven organischen Materials in der Dicke variiert, und dass die Wellenlänge des Laserlichts, das durch Anregung des ersten aktiven organischen Materials erzeugt wird, an der Stelle eine Funktion der Dicke der Schicht (112) des ersten aktiven organischen Materials ist, wo die optische Pumpenergie die Schicht (112) des ersten aktiven organischen Materials anregt.

15. Eine Vorrichtung, die einen Laser nach Anspruch 1 einschließt, wobei die Vorrichtung aus der Gruppe von Telekommunikationsgeräten, Druckern, optischen Geräten, Geräten zum Ätzen von Halbleiterstromkreisen, Geräten zur thermischen Bearbeitung, spektroskopischen Geräten, Fahrzeugkontrolleinrichtungen, Fahrzeugnavigationseinrichtungen, Messeinrichtungen, optischen Speichergeräten, Displays, Scannern, Pointern, Spielen, Unterhaltungssystemen und Sensoren ausgewählt ist.

## Revendications

1. Laser organique comprenant:
- une première couche à miroir (110) qui n'est pas un substrat;
- une couche (112) d'un premier matériau organique actif au-dessus de ladite couche à miroir (110), ledit premier matériau organique actif comprenant deux facettes réfléchissantes (113, 114) à peu près parallèles l'une par rapport à l'autre en formant de la sorte un résonateur optique dans la couche (112) de premier matériau organique actif ; et
- un moyen de pompage (118) ; où
- ledit premier matériau organique actif émet des faisceaux laser lorsque soumis au pompage par ledit moyen de pompage (118) afin de produire ainsi de la lumière laser (116) ; et
- ladite première couche à miroir (110) étant capable de réfléchir au moins une partie de la lumière produite par ledit premier matériau organique actif.

2. Laser selon la revendication 1, où ladite première couche à miroir (110) possède un indice de réfraction inférieur à un indice de réfraction du premier matériau organique actif.

3. Laser selon la revendication 1, où ladite première couche à miroir (110) comprend une pile de miroirs diélectriques à réflexion de Bragg.

4. Laser selon la revendication 1, où ladite première couche à miroir (110) comprend de l'InP.

5. Laser selon la revendication 4, où ledit premier matériau organique actif est déposé sur le miroir d'un cristal (100) dudit InP.

6. Laser selon la revendication 1 et comprenant par ailleurs une couche de placage (111) entre ladite première couche à miroir (110) et ladite couche (112) de premier matériau organique actif, ladite couche de placage (111) comprenant un matériau ayant un indice de réfraction inférieur à celui dudit premier matériau organique actif.

7. Laser selon la revendication 6, où ladite couche de placage (111) comprend du dioxyde de silicium.

8. Laser selon la revendication 1, où ladite couche (112) de premier matériau organique actif comprend un matériau organique hôte dopé avec un matériau dopant.

9. Laser selon la revendication 8, où ledit matériau organique hôte est sélectionné dans le groupe constitué d'aluminium de tris(hydroxyde-8-quinoline), de CBP, et de combinaisons de ceux-ci.

10. Laser selon la revendication 9, où ledit matériau dopant est sélectionné dans le groupe constitué de rhodamine-6G, de DCM, de DCM2, de coumarine-30, de coumarine-47, de pérylène, de pyrrométhane-546, et de combinaisons de ceux-ci.

11. Laser selon la revendication 10, où un spectre électroluminescent du matériau hôte et un spectre d'absorption du matériau dopant se superposent.

12. Laser selon la revendication 1, où ledit moyen de pompage (118) comprend une source d'énergie de pompage optique pour soumettre au pompage ledit premier matériau organique actif.

13. Laser selon la revendication 12, où ladite énergie de pompage optique comprend un laser d'azote.

14. Laser selon la revendication 12, où :
ladite couche (112) de premier matériau organique actif varie en épaisseur ; et où la longueur d'onde de la lumière laser produite par le pompage dudit premier matériau organique actif est une fonction de l'épaisseur de ladite couche (112) de premier matériau organique actif à l'emplacement où ladite énergie de pompage optique soumet au pompage ladite couche (112) de premier matériau organique actif.

15. Dispositif comprenant le laser selon la revendication 1, ledit dispositif étant sélectionné dans le groupe constitué par un appareil de télécommunication, un appareil d'impression, un appareil optique, un appareil d'impression par gravure de circuit de semiconducteur, un appareil de traitement thermique, un appareil de spectroscopie, un appareil de commande de véhicule, un appareil de navigation de véhicule, un appareil de mesure, un appareil de mémoire optique, un affichage, un scanner, un indicateur, un jeu, un système dans le domaine du spectacle, et un détecteur.
